# EUROPÄISCHE PATENTSCHRIFT

(11) **EP 1 186 681 B1**
(45) Veröffentlichungstag und Bekanntmachung des Hinweises auf die Patenterteilung: **31.03.2010**
(21) Anmeldenummer: 01119423.0
(22) Anmeldetag: 11.08.2001
(51) Int. Cl.: C23C 14/32, H01J 37/32, C23C 14/50, C23C 14/34

(54) **Vakuumanlage mit koppelbarem Werkstückträger**
Vacuum treatment apparatus having dockable substrate holder
Dispositif de traitement sous vide avec support de substrats couplable

(30) Priorität: 05.09.2000 CH 17272000
(43) Veröffentlichungstag der Anmeldung: 13.03.2002
(73) Patentinhaber: Oerlikon Trading AG, Trübbach, 9477 Trübbach (CH)
(72) Erfinder: Seeli, Roger, CH-9477 Truebbach (CH); Pedrazzini, Mauro, FL-9492 Eschen (LI); Derflinger, Volker, A-6800 Feldkirch (AT)

(56) Entgegenhaltungen:
- EP-A- 0 668 369
- EP-A- 0 885 981
- US-A- 4 877 505

## Beschreibung

Die vorliegende Erfindung betrifft eine Vakuumanlage zum Behandeln von Werkstücken, mit einer evakuierbaren Behandlungskammer, in deren Zentralachse eine Niedervoltbogen-Entladungsanordnung angeordnet ist, und mindestens einer an einer Seitenwand der Behandlungskammer angebrachten Beschichtungsquelle sowie einem Werkstückträger, auf dem Werkstücke gegebenenfalls auf zusätzlichen Werkstückhaltern montiert sind.

Im Stand der Technik ist es für verschiedene Vakuumbehandlungsprozesse bekannt, vor und/oder nach der Vakuumbeschichtung Reinigungs- und/oder Heizschritte vorzunehmen. Solche Schritte sind vor allem notwendig, um einer abzuscheidenden Schicht eine gute Haftfestigkeit zu verleihen. Besonders wichtig ist dies bei Anwendungen, wo Werkstücke, insbesondere Werkzeuge und mechanisch hochbelastete Bauteile, mit einer verschleissfesten Hartstoffschicht beschichtet werden sollen. Solche Schichten sind bei Werkzeugen, wie beispielsweise bei Bohrern, Fräsern und Umformwerkzeugen bzw. Bauteilen wie Zahnrädern, Nadeln für Einspritzdüsen, Tassenstösseln, Nockenwellen sowie andere schnell bewegte oder stark belastete Teile besonders hohen mechanischen und abrasiven Beanspruchungen ausgesetzt. Eine extrem gute Haftung mit der Unterlage ist deshalb Voraussetzung für einen brauchbaren und wirtschaftlichen Einsatz. Eine bewährte Methode solche Werkstücke vorzubehandeln ist einerseits das Heizen, insbesondere mit Elektronenbeschuss und andererseits das Ätzen mittels Ionenätzen beziehungsweise Zerstäubungsätzen. Das Beheizen mittels Elektronenbeschuss aus einer Plasmaentladung ist beispielsweise bekannt geworden aus der DE 33 30 144. Eine Plasmaentladungsstrecke kann auch verwendet werden, um schwere Edelgasionen zu erzeugen, beispielsweise Argonionen, welche aus diesem Plasma auf das Werkstück beziehungsweise das Substrat beschleunigt werden, um dort ein Zerstäubungsätzen zu bewirken, wie dies in der DE 28 23 876 beschrieben ist. Neben dem Zerstäubungsätzen ist es auch bekannt geworden, Plasmaentladungen mit zusätzlichen Reaktivgasen zu betreiben und die Werkstücke reaktivchemisch zu ätzen, wobei auch Mischformen zwischen diesem Reaktivätzen und dem Zerstäubungsätzen möglich sind. Unterstützend wird häufig bei den vorbeschriebenen Verfahren die Behandlungskammer mit einer Elektromagnet-Spulenanordnung umgeben, vorzugsweise nach Art von Helmholtz-Spulenpaaren, die es erlaubt, das Plasma zusätzlich zu beeinflussen, z. B. zur Erhöhung der Plasmadichte bzw. zur Konzentration des Plasmaeinschlusses, was einen stärkeren Ionenbeschuss bewirkt oder zur Steuerung der Plasmaverteilung in der Anlage beispielsweise durch Änderung der Spulenströme während der Plasmabehandlung und Ähnliches.

Bei all diesen Vorbehandlungsverfahren geht es darum, die Werkstücksoberfläche so vorzubereiten, dass die nachfolgende Beschichtung gut auf der Unterlage haftet. Zur Plasmaerzeugung wird bei den vorerwähnten Anordnungen eine Niedervoltbogenentladung verwendet, welche in der Zentralachse der Anlage angeordnet ist, wobei die Werkstücke in einem bestimmten Abstand um diesen Bogen herum und entlang einer Zylinderfläche angeordnet sind. Die Beschichtung erfolgt anschliessend mittels thermischem Aufdampfen oder Katoden-Zerstäuben oder Mischformen wie Arc-Verdampfen. Je nach Prozessführung wird hierbei durch entsprechenden Substratbias während der Beschichtung ein zusätzlicher Ionenbeschuss erzeugt, welches unter dem Begriff Ionenplattieren (ion plating) bekannt geworden ist.

Diese Anordnung hat den Vorteil, dass aus der Niedervoltbogenentladung grosse Ionenströme bei niederer Teilchenenergie gezogen werden können und somit das Werkstück schonend behandelt werden kann. Durch die bei physikalischen Verfahren notwendige bewegliche Anordnung der zu beschichtenden Teile um eine zentral in der Anlage angebrachte Vorrichtung zur Zündung eines Niedervoltbogens ergibt sich ein relativ komplizierter mechanischer Aufbau. So werden die zu beschichtenden Teile heute oft auf einzelnen rotationssymmetrisch um die Anlagenachse angeordneten, oder ihrerseits wieder auf bevorzugt karussellähnlichen Werkstückträgern drehbeweglich montierten, Werkstückhaltern befestigt. Weiters sind zur Durchführung der verschiedenen Prozessschritte unterschiedliche elektrische Potentiale an die zentral angeordnete Anode und die einzelnen Werkstückhalter bzw. den Werkstückträger anzulegen und diese gegenseitig und zusätzlich gegen die auf Masse gelegte Anlage elektrisch zu isolieren. Bei Bedarf sind für Temperatursensoren oder andere Messeinrichtungen noch weitere elektrische Durchführungen vorzusehen. Aufgrund der oben beschriebenen komplexen mechanischen und elektrischen Voraussetzungen wurden bei industriellen Anlagen zur gleichzeitigen Beschichtung einer grossen Anzahl oder einzelner entsprechend schwerer Teile, die Werkstückhalter bzw. karussellähnlichen Werkstückträger zwar drehbeweglich, aber nicht auf einfache Weise lösbar mit der Anlage bzw. dem Anlagenboden verbunden. Ein Be- und Entladen durch eine seitliche Öffnung ist dann jedoch, zudem noch aufgrund der zentralen Einbaulage der Niedervoltbogen-Entladungsanordnung, schwierig. Daher wurde im grossindustriellen Einsatz eine Anordnung gewählt, mit der es möglich ist, hydraulisch oder mit Spindelantrieben den Anlagenboden inclusive des darauf montierten Werkstückträgers abzusenken. Eine weitere denkbare Variante besteht darin, den Rezipienten nach oben abzuheben. Beiden gemeinsam ist die nachteilige Notwendigkeit, alle Versorgungsleitungen (z. B. Kühlwasser und Elektrik) für den als Ladeöffnung ausgebildeten Anlageboden bzw. Rezipienten in aufwendiger beweglicher Ausführung vorzusehen. Die notwendige Bauhöhe und die längeren Standzeiten solcher Anlagen bei Be- und Entladung sind darberhinaus unwirtschaftlich.

Um diesen Nachteilen zu begegnen wurde in US 5,709,784 eine Anlage offenbart, die besonders für die grossindustrielle Massenfertigung geeignet ist. Dabei konnte erstmals für PVD-Anlagen mit Niedervoltbogen-Entladungsanordnung dieser Grössenordnung (Beschichtungsbreite bis zu 1000mm und mehr) eine einfache Front-Be- und Entladung vorgesehen werden. Die mindestens eine Niedervoltbogen-Entladungsanordnung wurde dazu seitlich an den Rezipienten, mit ihrer linearen Ausdehnung parallel zu einem beweglichen Werkstückträger angebracht. Dem Handlingsvorteil der asymmetrischen Anordnung ausserhalb des zentralen Beschichtungsraums stehen im Vergleich zu einer zentralen Anordnung der Niedervoltbogen-Entladungsanordnung aber geometrisch bedingte Einschränkungen gegenüber.

Aufgabe der vorliegenden Erfindung ist es demnach, die aufgeführten Nachteile des Standes der Technik zu vermeiden, darüberhinaus kurze Behandlungszeiten von Werkstücken in einer Vakuumbehandlungsanlage zu erlauben, insbesondere kürzere Stillstandzeiten der Anlage, einfachere Bauweise und grössere Wirtschaftlichkeit.

Erreicht wird dies dadurch, dass der Werkstückträger durch eine kraft- und medienschlüssige Kopplungseinrichtung lösbar mit einer Aufnahmevorrichtung im Boden der Behandlungskammer verbunden ist und die Beschichtungskammer eine seitlich, bevorzugt auf der Vorderseite, angebrachte verschliessbare Öffnung aufweist, deren Querschnitt grösser als der des Werkstückträgers ist, so dass der Werkstückträger gemeinsam mit den gegebenenfalls auf zusätzlichen Werkstückhaltern montierten Werkstücken entkoppelt und aus der Vakuumanlage entfernt werden kann.

Der Einsatz der zentralen Niedervoltbogen-Entladungsanlage erlaubt ein Ätzen bzw. ionenunterstütztes Beschichten aus der Zentralachse der Behandlungskammer mit allen Vorteilen einer symmetrischen Anordnung einer solchen Entladungsanlage. Zudem werden Vorteile durch die Symmetrie einer möglichen magnetischen Plasmafokussierung erzielt. Die lösbare Kopplung von Werkstückträger und Aufnahmevorrichtung erlaubt ein schnelles Be- und Entladen des Werkstückträgers, vor allem durch durch die bevorzugte seitliche Öffnung in der Behandlungskammer.

In einer Ausführungsform sind am Werkstückträger kraftschlüssige Führungs- und Verbindungseinrichtungen vorgesehen, die mit entsprechenden Gegenstücken der Aufnahmevorrichtung der Vakuumanlage korrespondieren. Beim Entladen wird durch das Anheben des Werkstückträgers in der Vakuumanlage, z. B. mit einer geeigneten Hubvorrichtung, die Kopplung gelöst. Umgekehrt wird beim Beladevorgang durch das Absetzen des Werkstückträgers auf die Aufnahmevorrichtung in der Behandlungskammer eine kraft- und medienschlüssige Verbindung erreicht. In einer bevorzugten Ausführungsform werden die Führungs- und Verbindungseinrichtung der lösbaren Kopplung mit Führungsstiften, bevorzugt selbstzentrierenden Dornen, realisiert, die in entsprechende Vertiefungen, bevorzugt Bohrungen in der Aufnahmevorrichtung, eingreifen. In weiteren Varianten ist es möglich, die Dorne am Werkstückträger oder an der Aufnahmevorrichtung anzubringen oder eine Kombination von beidem. Weiterhin lässt sich durch eine asymmetrische Anordnung der Führungsstifte eine eindeutige Lagezuordnung Werkstückträger - Aufnahmevorrichtung erreichen.

Der Werkstückträger ist gemäss einer Ausführungsform der Erfindung rotierbar um die Zentralachse der Behandlungskammer ausgeführt. Die Erfindung lässt den Einsatz weiterer, dem Stand der Technik entsprechenden Ausführungen von Werkstückträgern, gegebenenfalls mit zusätzlichen Werkstückhaltern, die dem jeweiligen Einsatzzweck entsprechen, zu.

Für den Einsatz in einer Vakuumbeschichtungsanlage weiterhin vorteilhaft ist die drehbare Ausführung der Aufnahmevorrichtung für den Werkzeugträger in der Zentralachse der Behandlungskammer. Zusammen mit einem weiteren vorteilhaften Merkmal, einem motorischen Antrieb, ist es möglich, die zu behandelnden Werkstücke, gegebenenfalls auf zusätzlichen Werkstückhaltern, die wiederum als Karussell auf den Werkstückträgern ausgeführt sein können, an den Beschichtungs /Ätzquellen vorbeizubewegen, um eine gleichmässige Behandlung zu ermöglichen.

Wird die Aufnahmevorrichtung im wesentlichen als eine lotrechte Hohlachse ausgebildet, an deren oberem Ende, im Rezipienten, die Aufnahmevorrichtung angebracht ist, und deren unteres Achsenende im Atmosphärenbereich liegt, so kann mittels bekannter Vorrichtungen eine vakuumdichte Drehdurchführung realisiert werden. Vorteilhaft kann so der motorische Antrieb wartungsfreundlich zugänglich ausserhalb angebracht werden und durch die Hohlachse Mess-, Steuer- und Versorgungsleitungen (Stromversorgung, Biasspannung, Messleitungen, Kühlmedium) in die Behandlungskammer durchgeführt werden. Für elektrische Anschlüsse kann dies beispielsweise durch Schleif-, Gleit-, Feder oder Steckkontakte erfolgen.

Gemäss einer weiteren Ausführungsform der Erfindung weist die Vakuumanlage ein Gasschnellkühl-/heizsystem für die Behandlungskammer mit dem Werkstückträger und den Werkstücken auf, die es erlaubt, ein Gas über ein Gaseinlasssystem in die Behandlungskammer einströmen zu lassen und aktiv in der Anlage umzuwälzen. Zur Gasumwälzung können bevorzugt Teile der Vorvakuum-Erzeugungsvorrichtung mitgenutzt werden. Der Kühl-/Heizeffekt auf die Werkstücke wird bevorzugt und konstruktiv einfach erreicht, wenn im Umwälzsystem ein Gaswärmetauscher angebracht wird, der dem Gas Wärme entzieht oder zuführt. Die Rückkühlung des Wärmetauschers kann in bekannter Weise gegen Wasser oder Luft erfolgen, die Beheizung beispielsweise elektrisch. Als Gas kommen Helium, Stickstoff, Formiergas (Stickstoff mit wenigen Prozent Wasserstoff) oder andere im Stand der Technik bekannte Gase in Betracht. Eine Druckregeleinrichtung sorgt für einen Druckbereich zwischen im wesentlichen 100 mbar bis Atmosphärendruck, bevorzugt werden 800 mbar.

In einer weiteren vorteilhaften Ausführungsform können am Werkstückhalter, der Aufnahmevorrichtung oder an anderen geeigneten Teilen der Anlage mechanische oder elektromechanische Vorrichtungen vorgesehen werden, die es erlauben, eine definierte Be- und Entladeposition für Werkstückhalter und Aufnahmevorrichtung festzulegen oder einzuhalten. Die Einstellung einer solchen Position kann motorisch, vorteilhafterweise gesteuert, erfolgen. Geeignet sind hierfür beispielsweise Endschalter, induktive Näherungsschalter, mechanischer Anschlag oder gattungsverwandte Einrichtungen.

Die elektrischen Verbindungen für beispielsweise Substratbias oder Messleitungen können gemäss einer weiteren Ausführungsform über Kontakte erfolgen, die korrespondierend in Aufnahmevorrichtung und Werkstückhalter vorsehbar sind. Diese können bevorzugt als Schleif-, Gleit, Feder- oder Steckkontakte erfolgen. Je nach Ausführung der Führungs- und Verbindungseinrichtungen lassen sich so die medienschlüssigen Verbindungen als Punkt- zu Punktkontakt oder als Punkt- zu achsensymmetrischem ringförmigem Flächenkontakt oder weiteren bekannten Ausführungsformen realisieren.

Eine weitere vorteilhafte Ausführungsform besteht darin, die Anode als Bestandteil der Aufnahmevorrichtung, elektrisch davon isoliert, vorzusehen. Besonders einfach gestaltet sich eine zentral auf der Drehachse der Aufnahmevorrichtung angebrachte Anode. Ohne Funktionalitätseinbusse kann diese mitrotierend mit der Aufnahmevorrichtung ausgeführt werden. Je nach Ausführungsform kann die Anode unterhalb oder oberhalb der Aufnahmevorrichtung für den Werkstückträger angeordnet werden. In der oberhalb angebrachten Position kann die Anode in der Ebene der Aufnahmevorrichtung horizontal teilbar ausgeführt werden, so dass der obere lösbare Teil als Anodenkopf abnehmbar ist. Daraus ergeben sich Vorteile bei der Wartung und Anlagenreinigung.

Das zur Kühlung der Anode benötigte Medium, bevorzugt Kühlwasser, kann über ein im wesentlichen achsenparalleles Rohr in die im unteren Teil vorteilhafterweise als Hohlzylinder ausgebildete Anode eingespeist, durch entsprechende mechanische Einbauten im Kopf der Anode verteilt und anschliessend durch den Anoden-Hohlzylinder oder ein zweites im wesentlichen achsenparallelen Rohr abgeleitet werden. Die Zu- bzw. Ableitung erfolgt dabei vorteilhafterweise mit drehbeweglichen am unteren atmosphärenseitigen Ende der Anode befestigten Kopplungselementen.
Zusätzlich kann, je nachdem ob die gesamte Anode beim Ladevorgang in der Anlage verbleibt oder zumindest der Anodenkopf mit dem Werkstückträger aus der Anlage entnommen wird, eine zusätzliche, durch das Aufsetzen bzw. Abheben des Werkstückträgers automatisch betätigte Kopplung der Zu- bzw. Ableitung des Kühlmediums vorgesehen werden.

In einer weiteren, vorteilhaften Ausführung kann die Behandlungskammer der Vakuumanlage mit Magnetspulen nach Art eines Helmholtz-Spulenpaars zur Plasmabeeinflussung umgeben werden. Ein weiterer Vorteil ergibt sich, wenn mindestens eine der Spulen, bevorzugt die untere, im Durchmesser kleiner, am Anlagenboden aussen und konzentrisch um die Hohlachse der Antriebseinrichtung angelegt wird. Dies ermöglicht, die seitliche Be- und Entladeöffnung flexibler am Rezipienten anzuordnen. Überraschenderweise wird die Plasmabeeinflussungsmöglichkeit durch diese geänderte Dimensionierung kaum gestört. Eine weitere Ausführunsgform ermöglicht es, die im Duchmesser kleiner dimensionierte Spule mit mehr Windungen auszuführen und so einen weitere Möglichkeit zur Magnetfeldanpassung zu gewinnen. Auch wäre eine separate Strom/Spannungsversorgung für die untere Spule mit individueller Regelung möglich.

Die Erfindung wird nun anhand schematischer Figuren beispielsweise beschrieben.
Figur 1 zeigt eine aus dem Stand der Technik vorbekannte Vakuumanlage mit zentraler Niedervoltbogen-Entladungsanordnung.
Figur 2 zeigt eine dem Stand der Technik entsprechende Vakuumanlage mit asymmetrischer Niedervoltbogen-Entladungsanordnung.
Figur 3 erläutert eine erfindungsgemässe Ausführung einer Vakuumanlage.
Figur 4 ist ein Detail der Anordnung der Kopplungseinrichtung mit unterer Anodenanordnung,
Figur 5 mit oberer Anodenanordnung.
Figur 6 fasst die wesentlichen Merkmale einer bevorzugten Ausführungsform der Kopplungseinrichtung zusammen.

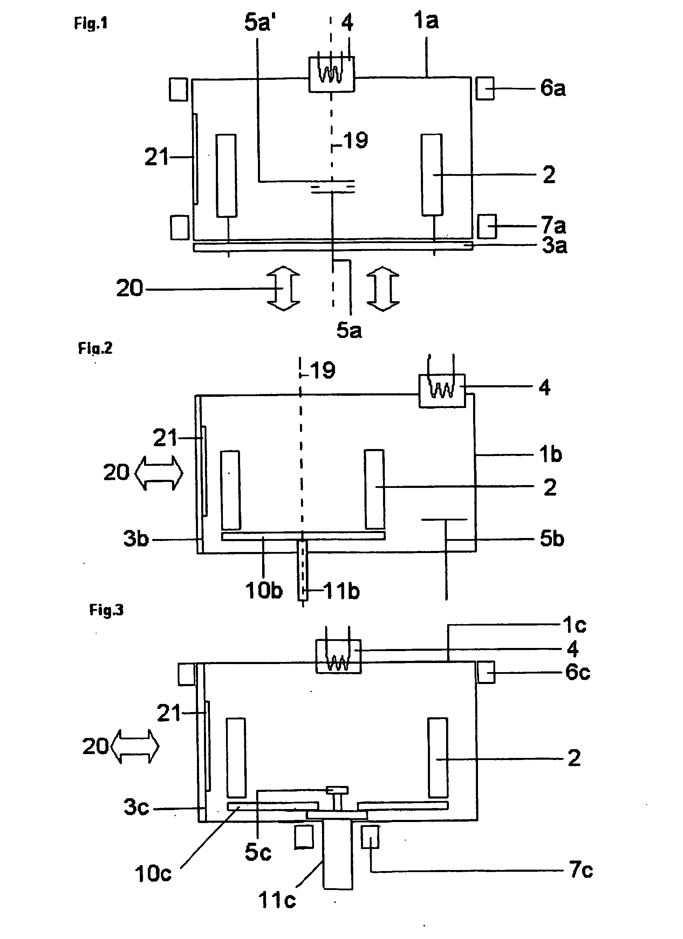

Figur 1 zeigt eine schematische Darstellung Anlage für den grossindustriellen Einsatz nach dem Stand der Technik. In der zentralen Achse 19 des Rezipienten 1a sind Ionisationskammer 4 und Anode 5 angeordnet. Letzere kann entweder von unten durch den Anlagenboden wie in 5a oder von oben wie in 5a' dargestellt in die Anlage eingeführt werden. Zur Stabilisierung des Niedervoltbogens sind weiters eine obere 6a und eine untere Spule 7a an der Anlage angebracht. Die drehbeweglich gelagerten Werkstückhalter 2 sind entweder direkt auf dem als Ladeöffnung 3a ausgebildeten Anlageboden oder auf einem ebenfalls auf der Ladeöffnung 3a montiertem hier nicht dargestellten ebenfalls drehbeweglich ausgeführten Werkstückträger befestigt.
Dadurch kann der durch die Bewegungspfeile 20 symbolisierte Be- und Entladevorgang nur durch ein Verschieben der Ladeöffnung 3a nach unten durchgeführt werden. Die daraus resultierenden Nachteile sind eine hohe Anlagenbauhöhe und ein entsprechender Raumbedarf sowie ein umständlicher, zeitaufwendiger Be- und Entladevorgang. Dasselbe gilt für eine hier nicht dargestellten Variante, bei der der Rezipient für den Be- und Entladevorgang nach oben abgehoben wird. Als weiterer Nachteil ergibt sich für beide Varianten die Notwendigkeit alle Versorgungsleitungen für den als Ladeöffnung 3a ausgebildeten Anlageboden bzw. Rezipienten 1a (Kühlwasser und Elektrik) in aufwendiger beweglicher Ausführung vorzusehen.

Figur 2 zeigt eine Vakuumanlage mit Niedervoltbogen-Entladungsanordnung mit einfacher Front-Be- und Entladeöffnung 3b. Die mindestens eine Niedervoltbogen-Entladungsanordnung bestehend aus einer Ionisationskammer 4 und Anode 5b ist dazu seitlich an den Rezipienten 16, parallel zu beweglich auf einem Werkstückträger 10 angebrachten Werkstückhaltern 2, angebracht.

Figur 3 Fig. 3. zeigt schematisch eine erfindungsgemässe Valuumbehandlungsanlage mit einem Rezipienten 1c, in der zentralen Achse 19 angeordnete Niedervoltbogen-Entladungsvorrichtung bestehend aus Ionisationskammer 4 und Anode 5c, oberer- 6c und unterer Spule 7c, Verdampferquelle(n) 21, Werkstückträger 10c, Werkstückhalter 2, sowie einer von vorne zugänglichen Ladeöffnung 3c. Weitere bekannte Anlagenkomponenten wie Vakuumpumstand, Gaszufuhr, Messröhren, Regel- und Steuerungseinrichtungen sowie Bedienelemente werden hier nicht weiter dargestellt.

Um trotz des drehbeweglich gelagerten Werkstückträgers eine aufwendige und dennoch leicht trennbare Medienversorgung mit vakuumdichten Übergang in den Rezipienten sicherzustellen (Substratspannung sowie bei Bedarf verschiedene Messpannungen an den Werkstückträger, Anodenspannung und Kühlwasser an bzw. in die Anode), wurden verschiedene erfinderische Lösungen vorgesehen, die in den folgenden Figuren beschrieben werden. Allen Ausführungen gemeinsam ist, dass der Werkstückträger 10 in einfacher Weise durch Anheben mit einer bekannten hier nicht näher dargestellten Hebevorrichtung, wie beispielsweise einem Gabelstapler, von den auf einer mit Lagern 23 versehenen Grundplatte 24 abgehoben und mit den darauf befestigten Werkstückhaltern 2 sowie beschichteten Werkstücken aus der Anlage entladen werden kann. Dabei genügt es, die Unterkante des Werkstückträgers mit genügenden Spiel über die Oberkante der Anode 5 zu heben. Insgesamt sind dafür nur wenige Zentimeter bis maximal etwa einen Dezimeter Hub aus der angekoppelten Beschichtungsposition notwendig.

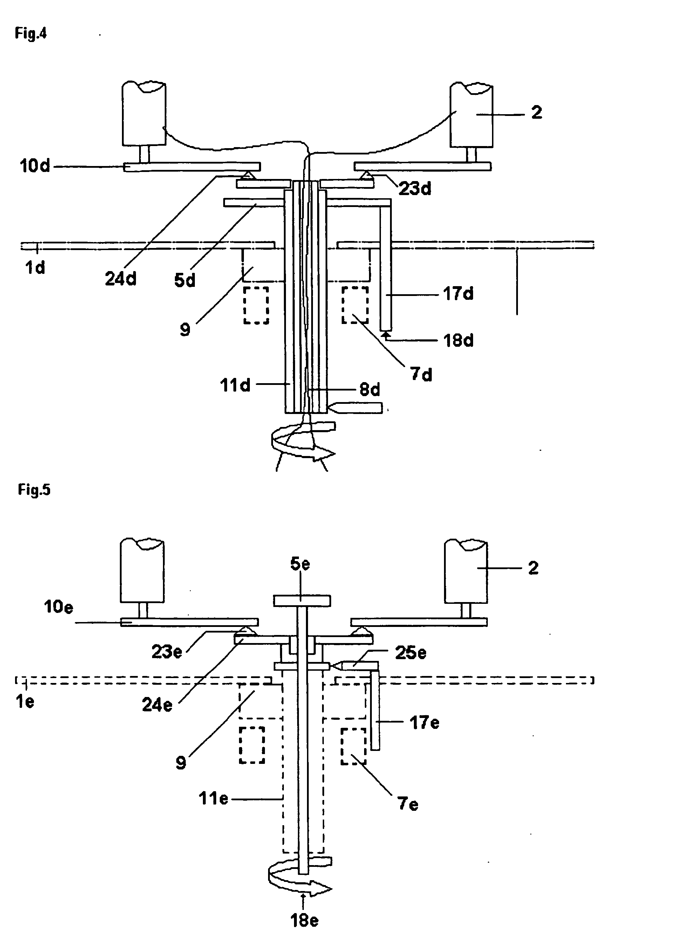

Die in FIG. 4 gezeigte erfinderische Ausführung zeigt ein mechanisch einfach zu verwirklichendes Konzept. Dabei ist die Anode 5d unterhalb der Grundplatte 24d bzw. unterhalb des Werkstückträgers 10d angebracht, wodurch die Kühlwasserzuleitung 18 und Anodenstromzuführung 17d exzentrisch erfolgen kann. Dies hat den Vorteil, dass in der Hohlwelle 11d mehr Platz für die anderen Medienleitungen verbleibt. Wichtig ist bei dieser Ausführung, Grundplatte 24d und / oder Werkstückträger 10d so zu bauen, dass der NiedervoltBogen möglichst ungestört von der hier nicht dargestellten Ionisationkammer auf die Anode 5d brennen kann. Dies ist beispielsweise durch Vorsehen von Speichen an Grundplatte 24d und / oder Werkstückträger 10d möglich. Um einen zu starken Ätzabtrag derartiger dem NV-Bogen ausgesetzten Einbauten zu verhindern, werden diese vorteilhafterweise mit vom Biaspotential isolierten auf Massepotential gelegten Blechen geschützt.

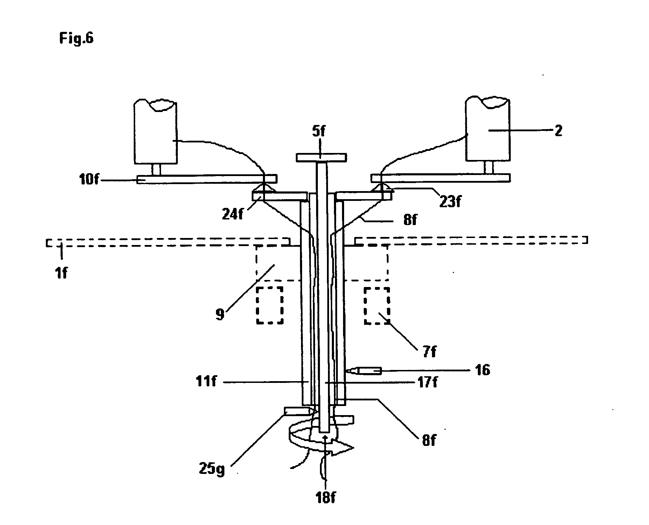

Bei den in FIG. 5 und 6 dargestellten Varianten wird die Anode 5 im wesentlichen parallel in oder etwas überhalb der Grundfläche des Werkstückträgers 10 angebracht, sodass zwischen Anode 5 und Ionisationskammer 4 eine freie optische Sichtverbindung besteht. Dadurch kann bei Beachtung der für Plasmaprozesse üblichen Dunkelraumabstände zwischen Einbauten unterschiedlichen Potentials ein stabiles NV-Plasma gezündet und aufrechterhalten werden, ohne dass sich störende Nebenplasmen ausbilden.

In FIG. 5 erfolgt die Anodenstromzuführung 17e über einen im Vakuum laufenden Schleifkontakt 25e, diese Ausführung ist vorteilhaft, wenn keine zusätzlichen Messleitungen für den Werkstückträger benötigt werden.

Eine besonders vorteilhafte Ausführung der Erfindung zeigt Fig. 6. Dabei erfolgt die Substratbias- 16 und die Anodenstromzuführung 17f atmosphärenseitig bevorzugt mittels Schleifkontakten 25g an die Hohlwelle 11f bzw. Anode 5f. Der Abgriff der mindestens einen in der Hohlwelle 11f geführten und mitbewegten Messelementzuleitung 8f,g erfolgt atmosphärenseitig über eine je nach Bedarf vorzusehende Anzahl von Gleitkontakten (nicht dargestellt). Die Signalübertragung von der Grundplatte 24f auf den Werkstückträger erfolgt über mindestens einen Steckkontakt wobei die Feinpositionierung vorzugsweise über ein mit beispielsweise ineinanderlaufende Kegelflächen zentriertes Lager 23f erfolgt.

Durch die erfindungsgemässe, durch einfaches Anheben lösbare Ankopplung des Werkstückträgers an die Grundplatte der Aufnahmevorrichtung ist es erstmals möglich an einer mit einer zentral angeordneten Niedervoltbogen-Entladungsvorrichtung versehenen PVD-Beschichtungsanlage (physical vapour deposition) eine Frontladeöffnung anzubringen. Dadurch ergibt sich im Vergleich zu anderen Anlagen mit gleichem oder ähnlichem Volumen der Anlagenkammer eine deutlich niedrigere Bauhöhe. Die damit gegebene Möglichkeit eines sehr raschen Be- und Entladevorgangs wirkt sich besonders vorteilhaft auf die Produktivität einer solchen Anlage aus. Werden beispielsweise zwei oder mehrere Werkstückträger verwendet, so kann ein Werkstückträger mit beschichteten Werkstücken gegen einen Werkstückträger mit unbeschichteten Werkstücken rasch ausgetauscht werden. Das Bestücken der Werkstückhalter kann somit während des Beschichtungsprozesses erfolgen.

Ein weiterer wesentlicher Vorteil der zentralen Anordnung der Niedervoltbogen-Entladungsvorrichtung ergibt sich dadurch, dass bei Bedarf auch während des Beschichtungsprozesses, insbesondere beim Übergang vom Ätz- auf den Beschichtungsvorgang eine zusätzliche Ionisierung erzielt werden kann. Dies hat sich bei insbesondere mit Reaktivgas durchgeführten Sputterprozessen häufig als vorteilhaft erwiesen. Beispielsweise ist es damit auch möglich definierte nanolamminaren Strukturen mit unterschiedlicher Schichtzusammensetzung abzuscheiden.

Mit vorliegender flexibler PVD-Anlage ist es erstmals möglich auch bei Arcbeschichtungen derartige Beschichtungsprozesse bzw. fliessende Übergänge zwischen Niedervoltbogen-Ätzen und Beschichtungsvorgang durchzuführen. Weiters kann bei Bedarf durch eine solcherart angeordnete Niedervoltbogen-Entladungsvorrichtung das Erwärmen der Werkstücke auf Prozesstemperatur durchgeführt werden.

Mit der erfindungsgemässen PVD-Anlage ist es erstmals möglich ohne Prozessunterbruch Sputter- und Arcbeschichtungsprozesse entweder getrennt, hintereinander oder auch gemischt zu fahren und gleichzeitig eine Plasmavorbehandlung bzw. Plasmaunterstützung durch ein zentrales Niedervoltbogenplasma vorzusehen.

## Patentansprüche

1. Vakuumanlage zum Behandeln von Werkstücken, mit einer evakuierbaren Behandlungskammer (1), in deren Zentralachse (19) eine Niedervoltbogen-Entladungsanordnung angeordnet ist, mindestens einer an einer Seitenwand der Behandlungskammer angebrachten Beschichtungsquelle (21), und einer seitlich, bevorzugt auf der Vorderseite der Behandlungskammer, angebrachten verschliessbaren Öffnung sowie einem Werkstückträger (10), auf dem Werkstücke gegebenenfalls auf zusätzlichen Werkstückhaltern (2) montiert sind, **dadurch gekennzeichnet, dass** der Werkstückträger (10) durch eine kraft- und medienschlüssige Kopplungseinrichtung lösbar mit einer Aufnahmevorrichtung im Boden der Behandlungskammer verbunden ist und, der Querschnitt der verschliessbaren Öffnung (3b, 3c) grösser als der des Werkstückträgers (10) ist, so dass der Werkstückträger gemeinsam mit den gegebenenfalls auf zusätzlichen Werkstückhaltern (2) montierten Werkstücken entkoppelt und aus der Vakuumanlage entfernt werden kann.

2. Vakuumanlage nach Anspruch 1, **dadurch gekennzeichnet, dass** die Kopplungseinrichtung unter anderem aus kraftschlüssigen Führungs- und Verbindungseinrichtungen an Werkstückträger und Aufnahmevorrichtung besteht, vorzugsweise am Werkstückträger (10) ausgebildet als Führungsstifte, besonders vorteilhaft als selbstzentrierende Dorne, weiterhin an der Aufnahmevorrichtung ausgebildet als Vertiefungen, die mit besagten Führungsstiften korrespondieren, besonders vorteilhaft als Bohrungen, so dass durch Anheben des Werkstückträgers mit einer geeigneten Hubvorrichtung eine Trennung der Kopplung respektive durch Absetzen des Werkstückträgers auf die Aufnahmevorrichtung die lösbare Verbindung erfolgt.

3. Vakuumanlage nach einem der vorhergehenden Ansprüche, **dadurch gekennzeichnet, dass** der Werkstückträger um die Zentralachse (19) der Behandlungskammer (1) rotierbar angeordnet ist.

4. Vakuumanlage nach einem der vorhergehenden Ansprüche, **dadurch gekennzeichnet, dass** die Aufnahmevorrichtung für den Werkstückträger (10) in der Zentralachse (19 ( der Behandlungskammer (1) drehbar angeordnet ist.

5. Vakuumanlage nach einem der vorhergehenden Ansprüche, **dadurch gekennzeichnet, dass** die drehbare Aufnahmevorrichtung im wesentlichen als lotrechte Hohlachse (11) mit einem motorischen Antrieb ausserhalb der evakuierbaren Behandlungskammer ausgeführt ist sowie Vorrichtungen zur Durchführung von Medien, bevorzugt Anodenstromversorgung (17), Substratbias (16), Kühlmedium (18) und Messleitungen(8), aufweist.

6. Vakuumanlage nach einem der vorhergehenden Ansprüche, **dadurch gekennzeichnet, dass** Mittel zur Festlegung der Be- und Entladeposition des Werkstückhalters in der Behandlungskammer vorgesehen sind, bevorzugt Endschalter, induktive Näherungsschalter, mechanischer Anschlag oder gattungsverwandte mechanische oder elektromechanische Vorrichtungen.

7. Vakuumanlage nach einem der vorhergehenden Ansprüche, **dadurch gekennzeichnet, dass** die elektrischen Verbindungseinrichtungen der lösbaren Kopplung aus Schleif-(25), Gleit- (26), Feder- oder Steckkontakten bestehen.

8. Vakuumanlage nach einem der vorhergehenden Ansprüche, **dadurch gekennzeichnet, dass** die Vakuumanlage ein Gasschnellkühl-/heizsystem für die Behandlungskammer mit den Werkstückträger und den Werkstücken aufweist mit einem Gaseinlasssystem, einer Gasumwälzvorrichtung und einem Gaswärmetauscher.

9. Vakuumanlage nach Anspruch 8, **dadurch gekennzeichnet, dass** das Gasschnellkühl-/heizsystem mit einer Druckregeleinrichtung versehen ist für einen Druckbereich zwischen im wesentlichen 100 mbar bis Atmosphärendruck, bevorzugt bei 800 mbar und dass als Gas Helium, Stickstoff oder Formiergas eingesetzt wird.

10. Vakuumanlage nach einem der vorhergehenden Ansprüche 1 bis 8, **dadurch gekennzeichnet, dass** die Anode der Niedervoltbogen-Entladungsanordnung zentrisch an der drehbaren Aufnahmevorrichtung angebracht ist.

11. Vakuumanlage nach Anspruch 10, **dadurch gekennzeichnet, dass** die Anode (5) in der Ebene der Aufnahmevorrichtung horizontal teilbar ist und der obere lösbare Teil als Anodenkopf abnehmbar ist.

12. Vakuumanlage nach einem der vorhergehenden Ansprüche 1 bis 8, **dadurch gekennzeichnet, dass** zur Plasmabeeinflussung an der Behandlungskammer Magnetfelderzeuger wie Permanentmagnete, bevorzugt Magnetspulen (6, 7) angebracht sind, vorzugsweise nach Art von Helmholtz-Spulen.

13. Vakuumanlage nach Anspruch 12, **dadurch gekennzeichnet, dass** eine der Spulen (7c) des Helmholtz-Spulenpaars einen kleineren Durchmesser aufweist als die andere (6c) und unterhalb der Behandlungskammer, zentrisch um die Zentralachse der Behandlungskammer orientiert, angeordnet ist.

14. Vakuumanlage nach Anspruch 13, **dadurch gekennzeichnet, dass** die Spulen sich in ihrer Windungszahl unterscheiden, bevorzugt die im Durchmesser kleinere eine höhere Windungszahl aufweist.

## Claims

1. Vacuum apparatus for treating substrates, with an evacuable treatment chamber (1), in the central axis (19) of which is arranged a low voltage arc discharge device, at least one coating source (21) arranged on a side wall of the treatment chamber and a closable orifice mounted on the side, preferably on the front of the treatment chamber, and a substrate holder (10) on which substrates are mounted, where applicable on additional workpiece carriers (2), **characterised in that** the substrate holder (10) is releasably connected by means of a force-fit and media-tight docking device with a receiver device in the base of the treatment chamber, and the cross-section of the closable orifice (3b, 3c) is greater than that of the substrate holder (10), so the substrate holder together with the substrates, mounted where applicable on additional workpiece carriers (2), can be decoupled and removed from the vacuum apparatus.

2. Vacuum apparatus according to claim 1, **characterised in that** the docking device amongst others comprises force-fit guide and connecting devices on the substrate holder and receiver device, preferably formed as guide pins on the substrate holder (10), particularly advantageously as self-centring mandrels, furthermore on the receiver device formed as recesses which correspond with said guide pins, particularly advantageously as bores, so that by raising the substrate holder with a suitable lift device the coupling is released, or by lowering the substrate holder onto the receiver device, the releasable connection is created.

3. Vacuum apparatus according to any of the preceding claims, **characterised in that** the substrate holder is arranged rotatably about the central axis (19) of the treatment chamber (1).

4. Vacuum apparatus according to any of the preceding claims, **characterised in that** the receiver device for the substrate holder (10) is arranged rotatably in the central axis (19) of the treatment chamber (1).

5. Vacuum apparatus according to any of the preceding claims, **characterised in that** the rotatable receiver device is designed substantially as a perpendicular hollow shaft (11) with a motor drive outside the evacuable treatment chamber and has devices for the passage of media, preferably anode power supply (17), substrate bias (16), coolant (18) and measurement lines (8).

6. Vacuum apparatus according to any of the preceding claims, **characterised in that** means for establishing the loading and unloading position of the substrate holder are provided in the treatment chamber, preferably limit switches, inductive proximity switches, mechanical stops or generically similar mechanical or electromechanical devices.

7. Vacuum apparatus according to any of the preceding claims, **characterised in that** the electrical connection devices of the releasable coupling comprise rubbing (25), sliding (26), spring or plug contacts.

8. Vacuum apparatus according to any of the preceding claims, **characterised in that** the vacuum apparatus has a rapid gas cooling and heating system for the treatment chamber with the substrate holder and the substrates with a gas inlet system, a gas circulation device and a gas heat exchanger.

9. Vacuum apparatus according to claim 8, **characterised in that** the rapid gas cooling and heating system is fitted with a pressure regulator for a pressure ranged substantially between 100 mbar to atmospheric pressure, preferably at 800 mbar, and that as a gas helium, nitrogen or forming gas is used.

10. Vacuum apparatus according to any of the preceding claims 1 to 8, **characterised in that** the anode of the low voltage arc discharge apparatus is mounted centrally on the rotatable receiver device.

11. Vacuum apparatus according to claim 10, **characterised in that** the anode (5) is horizontally divisible in the plane of the receiver device and the upper detachable part can be removed as the anode head.

12. Vacuum apparatus according to any of the preceding claims 1 to 8, **characterised in that** for plasma influence at the treatment chamber, magnetic field generators are fitted such as permanent magnets, preferably magnetic coils (6, 7), preferably in the manner of Helmholtz coils.

13. Vacuum apparatus according to claim 12, **characterised in that** one of the coils (7c) of the Helmholtz coil pair has a smaller diameter than the other (6c), and is arranged below the treatment chamber, centrally oriented about the central axis of the treatment chamber.

14. Vacuum apparatus according to claim 13, **characterised in that** the coils differ in their number of windings, preferably the smaller diameter coil has a higher number of windings.

## Revendications

1. Installation à vide destinée au traitement de pièces, comportant une chambre de traitement (1), dont l'air peut être évacué, sur l'axe central (19) de laquelle est disposé un dispositif de déchargement à arc à bas voltage, au moins une source de revêtement (21) placée sur une paroi latérale de la chambre de traitement, une ouverture verrouillable placée sur le côté, de préférence sur le côté avant de la chambre de traitement ainsi qu'un support de pièces (10) sur lequel des pièces sont montées le cas échéant sur des porte-pièces (2) supplémentaires, **caractérisée en ce que** le support de pièces (10) est relié de manière détachable, par un dispositif de couplage par adhérence et fluidique, à un dispositif récepteur dans le fond de la chambre de traitement et la section de l'ouverture verrouillable (3b, 3c) est supérieure à celle du support de pièces (10), de sorte que celui-ci peut être découplé en même temps que les pièces montées le cas échéant sur des porte-pièces (2) supplémentaires et retiré de l'installation à vide.

2. Installation à vide selon la revendication 1, **caractérisée en ce que** le dispositif de couplage est constitué, notamment, de dispositifs de guidage et de liaison par adhérence sur le support de pièces et le dispositif récepteur, de préférence sur le support de pièces (10), configurés en forme de goupilles de guidage, de manière particulièrement avantageuse en forme de goujons à centrage automatique, en outre configurés, sur le dispositif récepteur, en forme de cavités qui correspondent avec les dites goupilles de guidage, de manière particulièrement avantageuse en forme d'alésages, de sorte que lorsque le support de pièces est soulevé avec un dispositif de levage approprié, il se produit une séparation du couplage et, lors de l'abaissement du support de pièces sur le dispositif récepteur, la liaison détachable.

3. Installation à vide selon l'une quelconque des revendications précédentes, **caractérisée en ce que** le support de pièces est disposé de manière à pouvoir tourner autour de l'axe central (19) de la chambre de traitement (1).

4. Installation à vide selon l'une quelconque des revendications précédentes, **caractérisée en ce que** le dispositif récepteur destiné au support de pièces (10) est disposé de manière à pouvoir tourner sur l'axe central (19) de la chambre de traitement (1).

5. Installation à vide selon l'une quelconque des revendications précédentes, **caractérisée en ce que** le dispositif récepteur rotatif est essentiellement exécuté sous forme d'axe creux vertical (11) avec un entraînement motorisé à l'extérieur de la chambre de traitement dont l'air peut être évacué et comporte des dispositifs pour le passage de médias, de préférence pour l'alimentation en courant anodique (17), le bias (16) du substrat, le fluide de refroidissement (18) et les câbles de mesure (8).

6. Installation à vide selon l'une quelconque des revendications précédentes, **caractérisée en ce que** des moyens pour déterminer la position de chargement et de déchargement du support de pièces sont prévus dans la chambre de traitement, de préférence des interrupteurs fin de course, des interrupteurs de proximité inductifs, une butée mécanique ou bien des dispositifs mécaniques ou électromécaniques apparentés.

7. Installation à vide selon l'une quelconque des revendications précédentes, **caractérisée en ce que** les dispositifs de liaison électrique du couplage détachable sont constitués de contacts à frottement (25), à glissement (26), à ressort ou à fiche.

8. Installation à vide selon l'une quelconque des revendications précédentes, **caractérisée en ce qu'**elle présente un système de refroidissement/chauffage rapide à gaz pour la chambre de traitement comportant le support de pièces et les pièces, comprenant un système d'arrivée du gaz, un dispositif de recirculation du gaz et un échangeur de chaleur à gaz.

9. Installation à vide selon la revendication 8, **caractérisée en ce que** le système de refroidissement/chauffage rapide à gaz est doté d'un dispositif de régulation de la pression pour une plage de pression comprise entre essentiellement 100 mbar et la pression atmosphérique, de préférence égale à 800 mbar, et **en ce que** le gaz utilisé est de l'hélium, de l'azote ou un gaz de formation.

10. Installation à vide selon l'une quelconque des revendications précédentes 1 à 8, **caractérisée en ce que** l'anode du dispositif de déchargement à arc à bas voltage est disposée au centre du dispositif récepteur rotatif.

11. Installation à vide selon la revendication 10, **caractérisée en ce que** l'anode (5) peut être divisée horizontalement sur le plan du dispositif récepteur et la partie supérieure détachable, en tant que tête d'anode, est amovible.

12. Installation à vide selon l'une quelconque des revendications précédentes 1 à 8, **caractérisée en ce que** des générateurs de champ magnétique, tels que des aimants permanents, de préférence des bobines magnétiques (6, 7), sont placés, de préférence comme les bobines de Helmholtz, sur la chambre de traitement afin d'agir sur le plasma.

13. Installation à vide selon la revendication 12, **caractérisée en ce que** l'une des bobines (7c) de la paire de bobines de Helmholtz a un diamètre plus petit que celui de l'autre bobine (6c) et qu'elle est disposée sous la chambre de traitement, orientée de manière centrique autour de l'axe central de la chambre de traitement.

14. Installation à vide selon la revendication 13, **caractérisée en ce que** les bobines se distinguent par le nombre de leurs spires, de préférence celle ayant le plus petit diamètre a un nombre plus élevé de spires.
